(19)

Europäisches
Patentamt
European
Patent Office
Office européen
des brevets

(11) **EP 3 575 016 A1**

(12) **EUROPEAN PATENT APPLICATION**

(43) Date of publication:
**04.12.2019 Bulletin 2019/49**

(21) Application number: **18175498.7**

(22) Date of filing: **01.06.2018**

(51) Int Cl.:
*B22D 19/04* (2006.01)      *B22D 19/16* (2006.01)
*B22F 3/105* (2006.01)      *B22F 5/00* (2006.01)
*B22F 5/04* (2006.01)      *B22F 7/06* (2006.01)
*C30B 11/00* (2006.01)      *C30B 29/52* (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Siemens Aktiengesellschaft
80333 München (DE)**

(72) Inventor: **Mathai, Manu
Lincoln, LN5 7FD (GB)**

(74) Representative: **Maier, Daniel Oliver
Siemens AG
Postfach 22 16 34
80506 München (DE)**

(54) **IMPROVEMENTS RELATING TO THE MANUFACTURE OF SUPERALLOY COMPONENTS**

(57)      A method of forming a component, for example a turbine aerofoil, the component comprising a first metal alloy composition in at least a first region of the component and a second metal alloy composition in at least a second region of the component. The method comprises depositing the first and second metal alloy compositions into different sections of a mould, applying pressure to the first and second metal alloy compositions in the mould and applying a Spark Plasma Sintering process to the metal alloys. The product of this process may then be used in investment casting to form an outer layer of the component. The component comprising the outer layer may then be subjected to a further Spark Plasma Sintering process to bind parts of the component together. The component may then be heat treated. Apparatus for carrying out such methods are also provided.

Fig. 1

## Description

The present disclosure relates to methods of manufacturing components from metal alloys, the components comprising different metal alloy compositions in different regions of the component, which may provide improved mechanical and/or chemical properties and/or may allow a more cost effective manufacture compared to known metal alloy components. The present disclosure also relates to components provided by said methods and to apparatus for carrying out said methods.

In particular the disclosure is concerned with the manufacture of turbine aerofoils formed from nickel superalloy compositions which are tailored to meet specific requirements in specific regions of the component.

## Background

A turbine aerofoil (or airfoil) can be considered to comprise a tip region, an intermediate region and a root region. The tip region comprises the tip of the aerofoil blade. The root region is where the aerofoil is attached to a turbine rotor disc. The intermediate region is between the tip region and the root region and comprises a main part of the aerofoil blade. The mechanical and/or chemical properties required at each of these regions vary due to the different operating conditions, for example stress, strain and temperature, which each region experiences in use.

Single crystal superalloys may provide improved mechanical properties, for example enhanced creep resistance, in turbine aerofoils when compared to conventionally cast components which may comprise a polycrystalline or grained structure. However, investment casting to produce single crystal complex components has numerous difficulties, mainly due to the potential for developing a large number of spurious grains during casting, particularly in advanced blade designs comprising complex cooling passages. Also, casting yields (which is the weight of the casting divided by the amount of metal poured into the cast) for complex single crystal aerofoils are typically very low. Therefore the use of the single crystal superalloys in the manufacture of turbine aerofoils is very expensive which ultimately makes investment casting of an entire turbine aerofoil in a single crystal material very cost prohibitive.

Hence, there is a need for functionally graded turbine aerofoils which can be manufactured in a cost effective manner.

US 6,331,217 relates to the fabrication of complex single crystal shapes by casting numerous relatively simple single crystal sub-components and joining the sub-components together with a transient liquid phase bonding process. The bond region generally provides a weakness in the finished component and so is located in an area of the component which experiences low stress in use.

## Summary

It is one aim of the present invention, amongst others, to a method of forming a component that addresses at least one disadvantage of the prior art, whether identified here or elsewhere, or to provide an alternative to existing methods of forming said components.

For instance it may be an aim of the present invention to provide a method of manufacturing a turbine aerofoil having optimised mechanical and chemical properties in different regions of the turbine aerofoil.

The centrifugal pull at any location along an aerofoil is proportional to the mass, radial distance from the centre and the square of the angular velocity. Therefore the centrifugal pull in the tip region of the aerofoil is much greater than at the root region or the intermediate region of the aerofoil. It therefore may be one aim of the methods of the present invention to provide a tip region which has a relatively low density, for example a lower density than the intermediate region and the root region. Such a relatively low density can reduce the weight of the tip region without changing its dimensions and therefore reduce the centrifugal pull experienced by the tip region.

The intermediate region of the aerofoil supports centrifugal loads with a small cross section. It therefore may be one aim of the methods of the present invention to provide an aerofoil with high creep strength. It may also be an aim of the present invention to provide the intermediate region with high oxidation resistance due to the exposure of the intermediate region to hot gas streams in use and to provide an enhanced thermal-mechanical fatigue (TMF) capability/life.

It may be a further aim of the of the methods of the present invention to provide a root region with a high notched low cycle fatigue (LCF) strength and good stress corrosion cracking resistance.

It may be one aim of the methods of the present invention to provide a component with suitable mechanical properties whilst reducing the usage of expensive single crystal material.

According to the present disclosure there is provided methods of forming components and related apparatus as set forth in the appended claims. Other features of the invention will be apparent from the dependent claims, and the description which follows.

According to a first aspect of the present invention, there is provided a method of forming a component, the component comprising a first metal alloy composition in at least a first region of the component and a second metal alloy composition in at least a second region of the component, the method comprising the steps of:

a) depositing the first metal alloy composition into a first section of a mould;

b) depositing the second metal alloy composition into a second section of the mould, wherein the first and second metal alloy compositions are in contact with each other;

c) applying a pressure to the first and second metal alloy compositions in the mould;

d) applying an electrical current to the first and second metal alloy compositions to heat and sinter the first and second metal alloy compositions to form the component; and

e) removing the component from the mould.

The first and second metal alloy compositions are suitably metal alloy powders.

Suitably steps c) and d) are carried out after steps a) and b). Steps a) and b) can be carried out in any order. Steps c) and d) can be carried out in any order. Suitably step e) is carried out after steps a) to d).

For the avoidance of doubt, the first and the second metal alloy compositions are intended to be different metal alloy compositions. For example, the first and second metal alloy compositions may differ from each in other in the specific elements present and/or in the amounts of the specific elements present.

Suitably step d) is a Spark Plasma Sintering (SPS) process. Suitably step d) is carried out whilst the pressure applied in step c) is maintained. Typical SPS processes involve applying a uniaxial force and a pulsed direct electric current (DC) to the metal alloy powders, typically under low atmospheric pressure to enable high speed consolidation of metal alloy powders. SPS utilizes high amperage, low voltage, pulsed DC current and uniaxial pressure to consolidate the metal alloy powders. Processing is generally performed in a vacuum chamber in a controlled atmosphere. A typical SPS set-up is well known in the present state of the art. The system consists of a vertical single axis press and a built-in water-cooled energizing mechanism. Such a typical SPS set-up also includes a water-cooled vacuum chamber, a DC sintering pulse generator and a controller.

The mould referred to in the method of this first aspect may alternatively be termed a "die" or a "die case".

The inventor has found that the method of this first aspect may efficiently provide a component or a component part, for example an aerofoil or a core for a turbine aerofoil, comprising different metal alloy compositions in different regions of the component. The different metal alloy compositions in the different regions of the component may have an improved bonding compared to known techniques for forming such components which may involve a joining process after forming the different regions of the component. The method of this first aspect may therefore allow the formation of a component with different metal alloy compositions in different regions of the component which provide optimised mechanical properties in said regions of the component without the disadvantage of causing a weakness in the component where the different metal alloy compositions meet, as is common with known joining techniques.

Suitably the method of this first aspect comprises further steps of depositing metal alloy compositions into the mould to form components comprising said further metal alloy compositions in further regions of the component in addition to the first and second metal alloy compositions in the first and second regions. Suitably the method of this first aspect comprises step b1) of depositing a third metal alloy composition into a third section of the mould, wherein the second and third metal alloy compositions are in contact with each other.

In one embodiment, the component is an aerofoil, suitably a turbine aerofoil, and the first, second and third regions of the component are a tip region, an intermediate region and a root region of the aerofoil, respectively.

*Investment casting*

The method of this first aspect may comprise a further step f) of placing the component in a second mould and investment casting an outer layer around the component in the second mould. Therefore the component formed by steps a) to e) forms a part of component formed by step f), suitably an inner core of the component.

Suitably step f) is carried out after steps a) to e).

Suitably step f) comprises the steps of:

f1) depositing a first molten metal alloy composition into a first section of the second mould;

f2) depositing a second molten metal alloy composition into a second section of the second mould, wherein the first and second molten metal alloy compositions are in contact with each other.

In some embodiments, the first molten metal alloy composition has the same metal alloy composition as the first metal alloy composition of step a).

In some embodiments the second molten metal alloy composition has the same metal alloy composition as the second metal alloy composition of step b).

Suitably the first molten metal alloy composition has the same metal alloy composition as the first metal alloy composition of step a), and the second molten metal alloy composition has the same metal alloy composition as the second metal alloy composition of step b).

Suitably step f) is adapted to form the outer layer as a single crystal material.

The inventor has found that the casting of a single crystal outer layer of the component can provide the advantages of the single crystal material to the component without having to form the entire component from said single crystal material. This method can therefore provide a component with the advantageous mechanical properties of the single crystal material at a reduced manufacturing cost compared to known components. For example, the inventors have found this to be particularly advantageous in the manufacture of turbine aerofoils. The outer region of a turbine aerofoil is the region which is exposed to the highest temperature during engine operation. The outer region of the aerofoil is also the region where enhanced creep resistance is required and it is therefore the region where usage of single crystal material would provide the maximum benefit. The inner regions of the aerofoil are not exposed to as high a temperature as the outer surface of the aerofoil. Therefore the method of this first aspect comprising step f) as defined above can provide the advantages of the single crystal outer layer at a reduced cost due to the formation of a polycrystalline inner core.

In some embodiments, the method of this first aspect comprises a step g) of placing the component in contact with a second component. The component may be placed in contact with a second component (or component part) in order to form a more complete component. For example, the method of this first aspect may be used to form a turbine aerofoil and in step g) the turbine aerofoil may be placed in contact with an aerofoil root in order to join said aerofoil and root together in a later manufacturing step.

Suitably step g) is carried out after steps a) to f).

In some embodiments, the method of this first aspect comprises a further step h) of applying an electrical current to the component to heat the component and bind parts of the component together and/or to bind the component to a second component. In embodiments wherein step f) is carried out and wherein step g) of placing the component in contact with a second component is not carried out, step h) is carried out to improve the bonding of the outer layer to the inner core of the component.

In embodiments wherein step f) is carried out and wherein step g) of placing the component (which may be termed a "first component") in contact with a second component is carried out, step h) is carried out to improve the bonding of the outer layer to the inner core of the first component and to provide a bond between the first component and the second component. Suitably step h) is a Spark Plasma Sintering (SPS) process as described above.

Suitably step h) involves heating and therefore sintering and/or melting the parts of the component (or the component parts), specifically in regions of the components where the parts (or the component parts) join to each other.

Suitably step h) is carried out whilst applying pressure to the component and to the second component, if present.

According to a second aspect of the present invention, there is provided an apparatus adapted to carry out steps a) to e) of the method of the first aspect, the apparatus comprising:

a mould defining the shape of the component for receiving material;

electrodes arranged to supply electricity through material placed in the mould; and

a press arranged to apply pressure to material placed in the mould.

Suitably the apparatus comprises at least two pairs of electrodes, each arranged to supply electricity through material in different sections of the mould.

Suitably the apparatus comprises at least two presses arranged to apply pressure to material in different sections of the mould.

According to a third aspect of the present invention, there is provided a method of forming a component comprising an inner core and an outer layer, the component comprising a first metal alloy composition in at least a first region of the outer layer and a second metal alloy composition in at least a second region of the outer layer, the method comprising the steps of:

f) placing an inner core in an investment casting mould;

f1) depositing a first molten metal alloy composition into a first section of the investment casting mould;

f2) depositing a second molten metal alloy composition into a second section of the investment casting mould, wherein the first and second molten metal alloy compositions are in contact with each other;

f4) allowing the first molten metal alloy composition and the second molten metal alloy composition to solidify to form single crystal outer layer around the component core.

A step f4) may be carried out after at least one of steps f1) and f2). Step f4) may be carried out continuously as molten metal alloy composition is deposited into the mould.

The component core may be formed using steps a) to e) of the method of the first aspect.

The component and step f) may have any of the features and advantages described in relation to the first aspect.

Suitably the method of this third aspect comprises further steps of depositing molten metal alloy compositions into the mould to form components comprising said further metal alloy compositions in further regions of the component in addition to the first and second metal alloy compositions in the first and second regions. Suitably the method of this third aspect comprises step f3) of depositing a third molten metal alloy composition into a third section of the investment casting mould, wherein the second and third metal alloy compositions are in contact with each other.

According to a fourth aspect of the present invention, there is provided an apparatus for carrying out the method of the third aspect, the apparatus comprising:

a chill plate adapted for supporting the inner core;

a mould comprising first and second inlets, the mould adapted for enclosing the inner core and for receiving the first and second molten metal alloy compositions through the first and second inlets respectively;

a first reservoir for supplying the first molten metal alloy composition to the mould through the first inlet; and

a second reservoir for supplying the second molten metal alloy composition to the mould through the second inlet.

Suitably the mould comprises a third inlet for receiving a third molten metal composition and the apparatus comprises a third reservoir for supplying the third molten metal alloy composition to the mould through the third inlet.

In some embodiments, the mould comprises a fourth inlet for receiving a fourth molten metal composition and the apparatus comprises a fourth reservoir for supplying the fourth molten metal alloy composition to the mould through the fourth inlet.

According to a fifth aspect of the present invention, there is provided a method of forming a component comprising at least two component parts, the method comprising the steps of:

g) arranging the at least two component parts in contact with each other;

h) applying an electrical current to the at least two component parts to heat component parts and bind the at least two component parts together.

The method of this fifth aspect may have any of the suitable features of the method of the first aspect.

Step g) may involve applying pressure to the at least two component parts.

Suitably the at least two component parts comprise an inner core and an outer layer.

Suitably the component formed by the method of the first, third and fifth aspects is a turbine aerofoil.

According to a further aspect of the present invention, there is provided a component comprising an inner core and an outer layer, wherein the inner core comprises a polycrystalline metal alloy composition and wherein the outer layer comprises a single crystal metal alloy composition.

Suitably the component of this aspect is formed by a method of the first aspect and/or second and/or third aspect of the present invention.

## Brief Description of the Drawings

Examples of the present disclosure will now be described with reference to the accompanying drawings, in which:

Figure 1 is a perspective view of a component formed by a method according to the first aspect of the present invention;

Figure 2 is a schematic of an apparatus of the second aspect for carrying out a method according to the first aspect; and

Figure 3 is a schematic of an apparatus of the fourth aspect for carrying out a method according to the third aspect.

**Detailed Description**

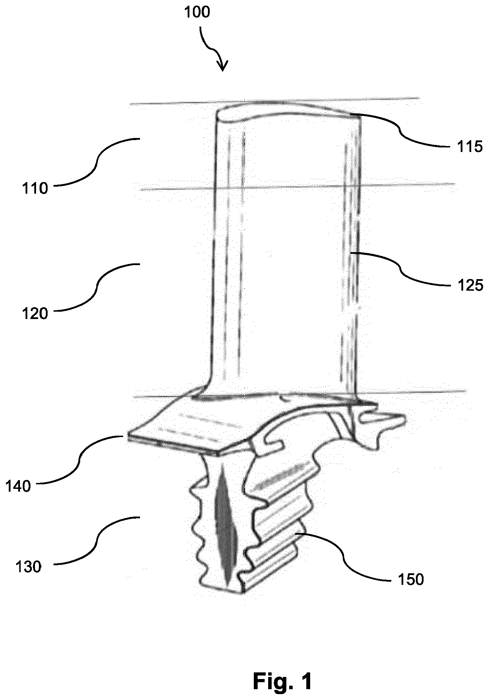

Figure 1 shows component (100) which is a turbine aerofoil formed of nickel-based alloys. The component (100) comprises a first region (110), a second region (120), a third region (130). The first region (110) of the component (100) comprises aerofoil tip (115) and extends approximately 10 mm from the tip along the aerofoil blade (125). The second region (120) of the component is an intermediate region comprising the main part of the aerofoil blade (125) which extends from the tip region (110) to the third region (130). The third region (130) of the component is a root region and comprises a platform (140) and a root (150), which are common parts of such turbine aerofoils with known functions.

The tip region (110) is formed of a nickel superalloy (a first metal alloy composition) comprising:

6.0 to 7.5 wt% aluminium;
8.0 to 10.0 wt% chromium;
5.0 to 7.0 wt% cobalt;
2.0 to 3.0 wt% tungsten;
0.5 to 1.0 wt% tantalum;
2.0 to 3.0 wt% niobium;
1.0 to 2.0 wt% molybdenum;
0.5 to 2.0 wt% titanium; and
nickel.

The first metal alloy composition is a nickel-based alloy, suitably a nickel superalloy. Suitably the metal alloy comprises at least 60 wt% nickel, suitably at least 65 wt% nickel. Suitably the metal alloy comprises up to 80 wt% nickel, suitably up to 75 wt%, for example up to 70 wt% nickel. It will be readily understood that the first metal alloy composition may contain other elements, in addition those listed above, and that the nickel provides the remainder of the metal alloy mass balance once these other elements have been taken into account. These other elements may be present in a total amount of up to 2 wt%, suitably up to 1 wt% or up to 0.8 wt%.

The inventor has found that the first metal alloy composition may advantageously have a relatively low density due to the combination of elements along with titanium compared to known nickel superalloys. This relatively low density means that the mass of the tip region can be relatively low and therefore the centrifugal loads transferred from the tip region of an aerofoil to the intermediate and/or root regions of the aerofoil are reduced which in turn reduces strain and wear on the intermediate and/or root regions of the aerofoil.

The density of the superalloy is a function of various elements and can be calculated by the following equation (I):

$$\text{Density} = 8.29604 - 0.00435\,(a.Co\%) - 0.0164\,(a.Cr\%) + 0.01295\,(a.Mo\%) + 0.06274$$
$$(a.\,W\,\%) - 0.06595\,(a.Al\,\%) - 0.0236\,(a.Ti\,\%) + 0.05441\,(a.Ta\%)$$

The density of the metal alloy composition can be reduced to the maximum extent by additions in aluminium and titanium. However, high levels of titanium may adversely affect oxidation resistance even when the aluminium content is high. Therefore only a relatively moderate amount of titanium of from 0.5 to 2.0 wt% is provided in the metal alloy composition of this first aspect.

Relatively high amounts of aluminium and tantalum and low levels of titanium and niobium in the metal alloy composition may enable good oxidation resistance and good coating compatibility. The presence of niobium, instead of further tantalum for example, may reduce the density at the tip of the aerofoil even further.

Less aluminium may be needed for oxidation resistance for forming protective $Al_2O_3$ scale in the metal alloy composition, due to the relatively high amounts of chromium (of from 8.0 to 10.0 wt%) and tantalum (of from 0.5 to 1.0 wt%) and the relatively low amounts of titanium. The amounts of niobium and vanadium may also be low in the metal alloy composition for the same reason.

Cobalt is present in the first metal alloy composition in an amount of from 5.0 to 7.0 wt% which may promote stability and hot corrosion resistance. If the cobalt content is below 3 wt%, the stability and hot corrosion resistance of the metal alloy composition may fall. If the cobalt content is above 10 wt%, the oxidation resistance may fall and the gamma prime solvus temperature may be reduced which would severely limit the elevated temperature rupture capability of a component formed of the metal alloy composition. The specified amount of cobalt may also be beneficial in providing some reduction in density.

Tungsten is present in the first metal alloy composition in an amount of from 2.0 to 3.0 wt% which may contribute to the creep rupture strength of the metal alloy composition because tungsten it is a good solid solution strengthener. If the amount of tungsten is less than 2.0 wt%, the rupture strength of a component formed of the metal alloy composition may be insufficient. However, if the tungsten content is greater than 5.0 wt% there is potential for instability and also the hot corrosion and oxidation resistance may be low.

The density of the first metal alloy composition may be determined to a certain extent by the amounts of refractory elements present. Therefore it may be advantageous to keep the content of refractory elements as low as possible to provide a relatively low density of the metal alloy composition. The contents of refractory elements influencing the density can be given by the equation (II) below:

$$\text{Refractory element content} = (0.5\ wt\%\ W) + wt\%\ Ta + wt\%\ Mo + wt\%\ Re + wt\%\ Ru$$

Suitably the first metal alloy composition comprises up to 8.0 wt% molybdenum, tungsten and tantalum (and ruthenium if present), suitably up to 7.5 wt%, suitably up to 7.0 wt%, for example up to 6.5 wt%.

The tip region (110) may be formed of a nickel superalloy (first metal alloy composition) comprising:

    6.0 to 7.5 wt% aluminium;
    8.0 to 10.0 wt% chromium;
    5.0 to 7.0 wt% cobalt;
    2.0 to 3.0 wt% tungsten;
    0.5 to 1.0 wt% tantalum;
    2.0 to 3.0 wt% niobium;
    1.0 to 2.0 wt% molybdenum;
    0.5 to 2.0 wt% titanium;
    0.05 to 0.15 wt% hafnium;
    0.05 to 0.10 wt% silicon;
    0 to 0.03 wt% yttrium;
    0 to 0.1 wt% carbon;
    0 to 0.05 wt% cerium and/or lanthanum; and
    nickel to balance.

The first metal alloy composition may consist essentially or consist of the elements listed above.

The inventor has found that, taking into account the various factors discussed above and the trade-off between low density and optimal creep resistance properties required at the tip region of the aerofoil, the first metal alloy composition may provide an optimised and advantageous material for the formation of a tip region of an aerofoil, suitably a turbine aerofoil.

The intermediate region (120) is formed of a nickel superalloy (second metal alloy composition) comprising:

    6.0 to 7.5 wt% aluminium;
    5.0 to 7.0 wt% chromium;
    5.0 to 8.0 wt% cobalt;
    3.0 to 5.0 wt% iron;
    6.0 to 8.0 wt% tungsten;
    6.0 to 8.0 wt% tantalum;
    1.0 to 3.0 wt% molybdenum;
    0.6 to 1.0 wt% titanium; and
    nickel.

This second metal alloy composition is a nickel-based alloy, suitably a nickel superalloy. Suitably the second metal alloy composition comprises at least 50 wt% nickel, suitably at least 55 wt% nickel, for example at least 60 wt% nickel. Suitably the second metal alloy composition comprises up to 75 wt% nickel, suitably up to 70 wt%, for example up to 65 wt% nickel. It will be readily understood that the second metal alloy composition may contain other elements, in addition those listed above, and that the nickel provides the remainder of the metal alloy mass balance once these other elements have been taken into account. These other elements may be present in a total amount of up to 2 wt%, suitably up to 1 wt% or up to 0.8 wt%.

The inventor has found that the second metal alloy composition may provide a region of a component, such as a turbine aerofoil, with a high creep strength and may have a high oxidation resistance. It is not as advantageous to have a relatively low density in said intermediate region of a turbine aerofoil as it is in the tip region, therefore the minimisation of the density may not be an important aim of the second metal alloy composition.

Suitably the second metal alloy composition comprises at least 16.0 wt% molybdenum, tungsten and tantalum (and ruthenium if present) suitably at least 17.0 wt%, suitably at least 18.0 wt%, for example at least 19 wt%. The inventor has found that such amounts of molybdenum, tungsten and tantalum (which may be known as refractory elements in such alloys) may provide the second metal alloy composition with a high creep strength which is particularly advantageous when the second metal alloy composition forms an intermediate region in an aerofoil, suitably a turbine aerofoil.

The contents of molybdenum, tungsten and tantalum may vary from greater than 18.0 wt% at highly creep resistant regions, for example at the intermediate region in an aerofoil, to less than 11.0 wt% in regions where less creep ductility is desired. The contents of molybdenum, tungsten and tantalum may be reduced to approximately 5 wt% at the root region of the aerofoil. In particular, a gradient of these elements is desired from root to tip.

The second metal alloy composition comprises a relatively low amount of chromium (for example compared to the first metal alloy composition) to account for the increased gamma prime phase content due to the relatively high amounts of molybdenum and tungsten and to avoid excessive topologically close packed phases (TCP).

The second metal alloy composition may comprise 0.05 to 1.5 wt% hafnium, suitably from 0.1 wt% to 1.5 wt%, suitably from 0.05 to 1.3 wt%, suitably from 0.1 to 1.3 wt%. Said content of hafnium may promote the stability of aluminium oxide scale which may in turn improve the oxidation resistance of the second metal alloy composition. However, higher amounts of hafnium may promote formation of gamma prime phase which may reduce alloy stability due to sigma phase formation.

The second metal alloy composition may comprise 0.05 to 0.10 wt% silicon, suitably from 0.07 wt% to 0.10 wt%, suitably from 0.05 to 0.07 wt%. Said content of silicon may improve the oxidation resistance of the second metal alloy composition. However, higher amounts of silicon may reduce the strength of a component formed of the second metal alloy composition due to formation of a weak beta phase.

The second metal alloy composition may comprise up to 0.03 wt% yttrium. Said content of yttrium may promote aluminium scale stability and adherence. Higher amounts of yttrium may promote undesirable mould metal reaction at the casting surface and subsequently increase the inclusion content in the material.

The second metal alloy composition may comprise 0 to 0.1 wt% carbon.

The second metal alloy composition may comprise 0 to 0.05 wt% cerium and/or lanthanum. Suitably the amount of cerium and lanthanum in the second metal alloy composition combined is from 0 to 0.05 wt%. Said content of cerium and/or lanthanum may promote oxidation resistance of the second metal alloy composition.

The second metal alloy composition may comprise any one or more of the following elements: 0.1-0.3 wt% wt% vanadium, 0.05 to 0.15 wt% hafnium, 0.05 to 0.10 wt% silicon, 0 to 0.1 wt% carbon, 0 to 0.05 wt% cerium and/or lanthanum.

The second metal alloy composition may comprise 0.1-0.3 wt% vanadium, 0.05 to 0.15 wt% hafnium, 0.05 to 0.10 wt% silicon, 0 to 0.1 wt% carbon, 0 to 0.05 wt% cerium and/or lanthanum.

In addition, minor amounts of boron and zirconium may be added to increase the creep rupture ductility desired in this intermediate region of a turbine aerofoil. Boron and zirconium segregate to grain boundary regions due to the misfit with the nickel matrix (gamma phase). The addition of boron is also seen to modify the presence of deleterious grain boundary carbides which are detrimental to creep ductility. The second metal composition may therefore comprise approximately 0.01 wt% boron and approximately 0.01 wt% zirconium.

The intermediate region (120) may be formed of a nickel superalloy (second metal alloy composition) comprising:

6.0 to 7.5 wt% aluminium;
5.0 to 7.0 wt% chromium;
5.0 to 8.0 wt% cobalt;
3.0 to 5.0 wt% iron;
6.0 to 8.0 wt% tungsten;
6.0 to 8.0 wt% tantalum;
1.0 to 3.0 wt% molybdenum;
0.6 to 1.0 wt% titanium;
0.1 to 0.3 wt% vanadium;
0.05 to 1.5 wt% hafnium;
0.05 to 0.10 wt% silicon;
0 to 0.1 wt% carbon;
0.005 to 0.01 wt% boron;
0.005 to 0.01 wt% zirconium;
0 to 0.05 wt% cerium and/or lanthanum; and
nickel to balance.

The second metal alloy composition may consist essentially or consist of the elements listed above.

The inventor has found that, taking into account the desired properties of an intermediate region of an aerofoil, the second metal alloy composition may provide an optimised and advantageous material for the formation of an intermediate region of an aerofoil, suitably a turbine aerofoil.

This root region (130) is formed of a nickel superalloy (a third metal alloy composition) comprising:

3.0 to 5.0 wt% aluminium;
10.0 to 13.0 wt% chromium;
5.0 to 7.0 wt% cobalt;
3.0 to 5.0 wt% tungsten;
6.0 to 9.0 wt% tantalum;
3.0 to 5.0 wt% niobium
0.0 to 0.25 wt% molybdenum;
0.7 to 1.0 wt% titanium; and
nickel.

This third metal alloy composition is a nickel-based alloy, suitably a nickel superalloy. Suitably the third metal alloy composition comprises at least 50 wt% nickel, suitably at least 55 wt% nickel, for example at least 60 wt% nickel. Suitably the third metal alloy composition comprises up to 80 wt% nickel, suitably up to 75 wt%, for example up to 70 wt% nickel. It will be readily understood that the third metal alloy composition may contain other elements, in addition those listed above, and that the nickel provides the remainder of the metal alloy mass balance once these other elements have been taken into account. These other elements may be present in a total amount of up to 2 wt%, suitably up to 1 wt% or up to 0.8 wt%.

The inventor has found that the third metal alloy composition may provide a region of a component, such as a turbine aerofoil, having a good low cycle fatigue (LCF) strength and good stress corrosion cracking (SCC) resistance, which is particularly advantageous in a root region of an aerofoil. The good stress corrosion cracking resistance is believed to be due to the chromium content of the third metal alloy composition being at least 10 wt% and more specifically from 10 to 13 wt%.

The inventor has also found that the third metal alloy composition may provide a moderately low density material which is advantageous for a root region of an aerofoil because this region provides a large fraction of the total mass of the aerofoil and reducing mass in this region is very helpful in minimising the total mass of aerofoil.

The tantalum content of at least 6 wt%, or more specifically from 6 to 9 wt%, is believed to provide solution strengthening to gamma prime particles contained in the third metal alloy composition.

In the third metal alloy composition, the amount of molybdenum is relatively low (for example compared to the first and second metal alloy compositions) and has been replaced by the specified amount of tantalum to improve resistance to the hot corrosion processes which are experienced by a root region of an aerofoil, suitably a turbine aerofoil, in use. A moderate amount of niobium is added in place of more tantalum in order to reduce the density at the root region of the aerofoil.

The third metal alloy composition may comprise 0.05 to 0.15 wt% hafnium, suitably from 0.07 wt% to 0.15 wt%, suitably from 0.05 to 0.13 wt%, suitably from 0.07 to 0.13 wt%. Said content of hafnium may promote the stability of aluminium oxide scale which may in turn improve the oxidation resistance of the metal alloy composition. However, higher amounts of hafnium may promote formation of gamma prime phase which may reduce alloy stability due to sigma phase formation.

The third metal alloy composition may comprise 0 to 0.1 wt% carbon.

The third metal alloy composition may comprise 0.05 to 0.15 wt% hafnium and/or 0 to 0.1 wt% carbon.

This root region (130) may be formed of a nickel superalloy (a third metal alloy composition) comprising:

3.0 to 5.0 wt% aluminium;
10.0 to 13.0 wt% chromium;
5.0 to 7.0 wt% cobalt;
3.0 to 5.0 wt% tungsten;
6.0 to 9.0 wt% tantalum;
3.0 to 5.0 wt% niobium;
0.0 to 0.25 wt% molybdenum;
0.7 to 1.0 wt% titanium
0.05 to 0.15 wt% hafnium;
0 to 0.1 wt% carbon; and
nickel to balance.

The third metal alloy composition may consist essentially or consist of the elements listed above.

Wherein the first, second and third metal alloy compositions form an outer layer of the component which a single crystal material, any boron, zirconium and/or hafnium may be omitted from said metal alloy compositions.

The inventor has found that, taking into account the desired properties of a root region of an aerofoil, the third metal alloy composition may provide an optimised and advantageous material for the formation of a root region of an aerofoil, suitably a turbine aerofoil.

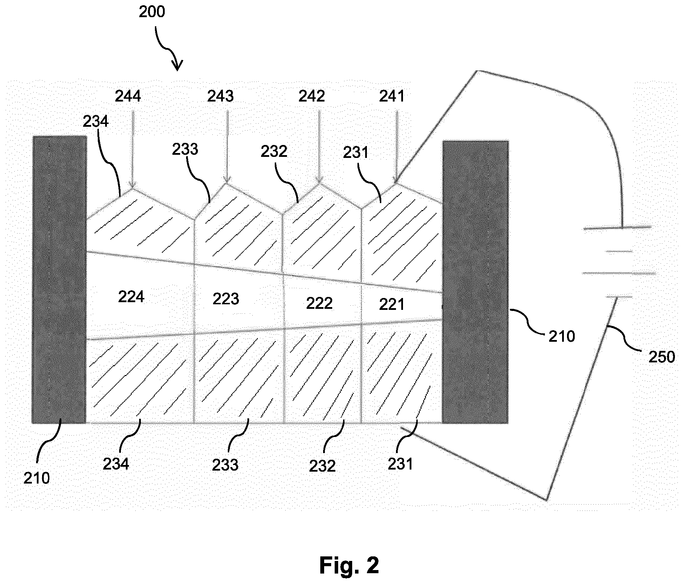

The turbine aerofoil of Figure 1 is formed from the method of the first aspect. Figure 2 shows a schematic of the apparatus (200) used to form a component, or an inner core of the component (100) of Figure 1, by a method of Spark Plasma Sintering. Apparatus (200) comprises mould (or "die case") (210) having four mould cavity sections (221, 222, 223 and 224). Four pairs or electrodes (231, 232, 233 and 234) are arranged above and below the four mould cavity sections (221, 222, 223 and 224) for conducting electricity through material in the respective mould cavity sections. Four presses (241, 242, 243 and 244) are arranged above the mould cavity sections for pressurising material in the mould cavity sections. The apparatus also comprises electrical circuit (250) for supplying electrical current to the four pairs of electrodes (231, 232, 233 and 234).

In order to form the component (100), the first metal alloy composition described above is deposited into the mould cavity section (221), the second metal alloy composition is deposited into the mould cavity sections (222 and 223) and the third metal alloy composition is deposited into the mould cavity section (224). These metal alloy compositions are in the form of powders. The powder metal alloy compositions are therefore arranged between the sides of the mould (die) and between the pairs of electrodes (231, 232, 233 and 234). Pressure is applied to metal alloy compositions through the presses (241, 242, 243 and 244), for example approximately 100 MPa of pressure. Electrical current is applied in pulses to the metal alloy compositions through the pairs of electrodes (231, 232, 233 and 234). This raises the temperature of the metal alloy powders rapidly to around 1300 °C above the ambient temperature in a few minutes. This results in a short period of heating and causes sintering of the surface of the powders of the metal alloy compositions which subsequently results in the production of a high quality sintered compact component in a few minutes. For example, heating may be carried out for approximately 2 minutes.

The component has the different first, second and third metal alloy compositions in the respective tip, intermediate and root regions to provide a gas turbine aerofoil with advantageous properties, as discussed above. Cooling passages may be formed within the component by positioning a ceramic insert appropriately in the metal alloy compositions. Such a ceramic insert can be later dissolved to leave a void defining the required cooling passage. Mechanical vibration of the mould can be used to ensure complete filling of the mould. The use of a plurality of electrode pairs and presses (four in this case) in series enables the application of optimised pressure and temperature conditions in each mould cavity section for the different metal alloy compositions. In some embodiments, the electrodes may be operated sequentially if the desired temperatures and pressures of the different metal alloy compositions are more or less similar. Due to the direct method used for the heating, it is possible to use very high heating and cooling rates during the process. Specifically, heating rates as high as 1000 °C/min are achievable. The high heating and cooling rates may advantageously favour densification over grain growth which promotes diffusion mechanisms thereby enabling a relatively high density component product, close to 100 % of the desired density of the final component.

Apparatus (200) can therefore provide, using a method of the first aspect, a gas turbine aerofoil (100) having the different and advantageous metal alloy compositions discussed above in the tip, intermediate and root regions of the gas turbine aerofoil.

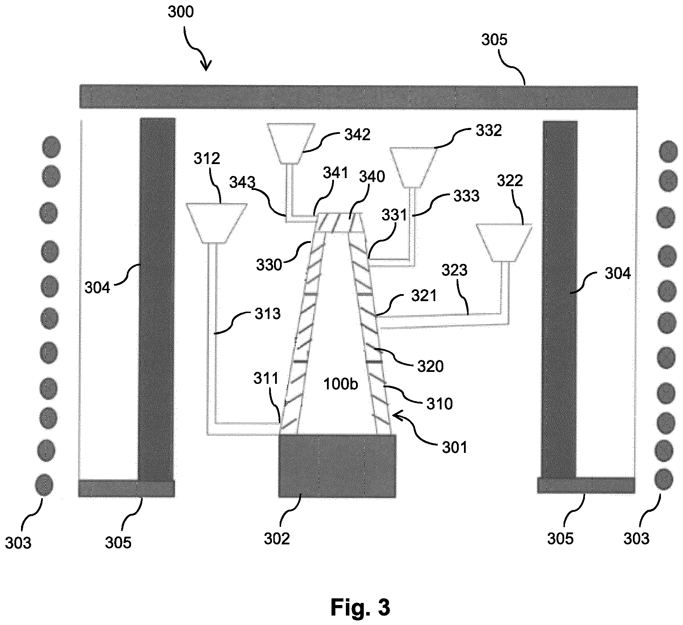

The component (100) formed as described above using apparatus (200) can be subjected to further processes to form a final component (for example a gas turbine aerofoil). Figure 3 is a schematic of an apparatus (300) for casting an outer layer around an inner core according to a method of the third aspect of the present invention. The inner core may be an inner core of the gas turbine aerofoil (100) formed using the apparatus (200) as described above.

The apparatus (300) comprises mould (301) formed from a refractory material, the mould (301) surrounding inner core component (100b) arranged on top of a chill plate (302). The mould comprises four mould sections (310, 320, 330 and 340), each having an inlet (311, 321, 331 and 341) arranged in communication with a reservoir (312, 322, 332 and 342) through conduits (313, 323, 333 and 343). The four mould sections (310, 320, 330 and 340) are open to each other (and are therefore only theoretically divided) and therefore have to be filled sequentially from their respective reservoirs. The reservoirs, conduits and inlets are adapted to supply molten metal alloy compositions from the reservoirs and into the mould. The mould (301) is arranged inside a vacuum chamber of a heated furnace comprising graphite susceptors (304) and induction coils (303) for heating the mould, and insulation sleeves (305) for slowing heat loss from the mould.

The apparatus (300) is used to carry out an investment casting method to provide an outer layer on the inner core (100b) using the following procedure. The component inner core (100b) is placed in the investment casting mould (301) on chill plate (302). A first molten metal alloy composition having the composition of the first metal alloy composition discussed above is placed in the reservoir (342), a second molten metal alloy composition having the composition of the second metal alloy composition discussed above is placed in the reservoirs (332) and (322), and a third molten metal alloy composition having the composition of the third metal alloy composition discussed above is placed in the reservoir (312). Then the third molten metal alloy composition is introduced into the mould section (310) of the investment casting mould (301), which provides the root region of the aerofoil. The susceptors (304) are heated by the induction coils (303) to keep the third molten metal alloy composition in a molten state. The mould (301) is then withdrawn (i.e. downwards with respect to the arrangement of Figure 3) from the apparatus (300) at a rate of 2.0-2.5 mm per hour, for example. The third molten metal alloy composition in the mould section (310) solidifies as it is withdrawn from the apparatus (300) due to the cooling provided by the cooling plate to form directionally solidified material, preferably single crystal material.

Directional solidification is enabled by the arrangement of chill plate (302), insulating sleeves (305), susceptors (304) and induction coils (303). Directional solidification is achieved by having a high G/R ratio where G is the temperature gradient at the solidifying front and R is the withdrawal rate of the casting mould from the investment casting apparatus. During directional solidification, the solidification front of the third molten metal alloy composition moves in a direction away from the chill plate (302). The directional solidification of the third molten metal alloy composition forms the outer layer of the root region of the component (100).

Prior to the complete solidification of the third molten metal alloy composition, when a portion of the third molten metal alloy composition is still in a molten state, the second molten metal alloy composition is introduced into the mould section (320) from the reservoir (322) through inlet (321) and solidified gradually as discussed above.

This process is repeated with the second molten metal alloy composition from reservoir (332) and the first molten metal alloy composition from reservoir (342). The withdrawal of the mould (301) from the furnace of apparatus (300) is continued until the top of the component (100) (the tip of the turbine aerofoil) has completely solidified with a columnar, single crystal microstructure. This provides turbine aerofoil (100) with a single crystal outer layer having different metal alloy compositions in different regions, each different metal alloy composition providing the favourable properties in the specific regions of the turbine aerofoil discussed above.

In some embodiments, the inner core (100b) is a component formed as described above in relation to Figure 2 and therefore the turbine aerofoil (100) as described in relation to Figure 1 is provided, having the same metal alloy compositions in the tip, intermediate and root regions in both in the inner core and the outer layer, providing a particularly advantageous turbine aerofoil (100).

A further step in the manufacturing process of component (100) may then be carried out to provide an improved bond between the different regions of the turbine aerofoil, namely between the outer layer formed from investment casting, the inner core formed through SPS as described above and any further part added to the component, such as an aerofoil root.

This further process is carried out by arranging the component (100) having the inner core (100b) and the outer layer described above in a suitable apparatus and applying an electrical current to these two component parts to heat and bind them together more effectively than is possible directly from the casting step discussed above. Therefore this process is a further Spark Plasma Sintering process.

In some embodiments, the processes described above are carried out to form a turbine aerofoil comprising the tip region and the intermediate region, as discussed above, from the first metal alloy composition and the second metal alloy composition. The root region of the turbine aerofoil may be formed separately (as a root region part) from the third metal alloy composition and then joined to the aerofoil (comprising the tip region and the intermediate region) during this further Spark Plasma Sintering process by placing the root region part in contact with the aerofoil as described above. In such embodiments, the aerofoil may comprise the outer layer of single crystal material in the tip and intermediate regions and the root region part may not comprise such an outer layer. The advantages of having such an outer layer of single crystal material are less in the root region than in the tip and intermediate regions and may therefore be omitted from the root region, potentially to save cost of manufacture of the aerofoil.

A suitable apparatus for carrying out this process comprises electrodes which can be arranged in close proximity to the opposing contact surfaces of the inner core and the outer layer. To enhance bonding and to ensure adequate contact pressure is developed between the opposing contact surfaces, a thin layer of metal or ceramic particles can be disposed between the contacting surfaces.

Additionally, melting point suppressants such as commercially available boron-containing foil and paste can be used between the contacting surfaces of the component parts to enhance the formation of the metallurgical bond between the contacting surfaces. While maintaining a pressure on the component parts of 1-200 MPa, a pulsed electric current having an intensity around 500-8,000 A is applied to the component (100) so that the temperature of the assembly is rapidly raised to between 1,300-1,500 °C. It is also possible for the time at which the desired temperature is held constant to be varied depending on the complexity of the part. A desired hold time could vary from 1 minute to 20 minutes, for example.

Although uniaxial pressure application through a ram or press is not generally desired in this final bonding step, an auxiliary ram could be used to apply uniaxial pressure to aid the bonding if desired.

The desired temperature during this SPS process should be below the gamma prime solvus temperature of the metal alloy compositions in the outer layer of the component (100) so that the advantageous single crystal structure at the outer surface of the aerofoil is retained by avoiding recrystallization. Advantageously the use of SPS hinders the recrystallization of the single crystal outer layer, as recrystallization is typically favoured with time and due to the rapidity of the sintering process, undesirable recrystallization seen in prior art bonding processes can be totally avoided.

At the end of the heating process, the electric field is reduced to allow the bonding surfaces to cool down. Due to the rapid heating and cooling processes, the possibility of recrystallization in the single crystal surfaces is greatly reduced when compared with other bonding processes like hot isostatic pressing combined with diffusion bonding. Also, due to the use of the SPS process, the final component (100) may have improved bonding reliability compared to similar components formed using methods of the prior art. Bonding processes which rely on diffusion heating of the component surfaces to be joined, such as hot isostatic pressing (HIP), can involve very slow heating rates and an inefficient process which may produce reduced bond strength and the formation of undesired microstructure in the bonded component parts. Such undesired microstructure may reduce the mechanical performance of the component.

This SPS process may also be used to form a component comprising at least two component parts which have been formed separately, by arranging the at least two component parts in contact with each other and applying an electrical current to the at least two component parts to heat and bind the at least two component parts together, as described above. For example, the root of the turbine aerofoil may be formed separately to the aerofoil blade and then joined by this process to provide a strong and robust joint between the component parts.

After forming, the component is suitably subjected to a heat treatment in order to attain optimal properties. An example of a suitable heat treatment step is as follows:

A solutioning, homogenization and 'reduction in casting porosity' step by Hot Isostatic Pressing (HIP) consisting of:

a ramp up to 1,225 °C and 150 MPa (HIP) in 120 minutes,
a ramp up from 1,225 to 1,275 °C in 250 minutes,
a hold for 50 minutes at 1,275°C,
a ramp down to 850 °C at 10 °C/minute while decreasing the pressure, and
a ramp down to ambient conditions at 70 °C/minute while further decreasing the pressure.

Further ageing heat treatment may then be carried at the end of HIP treatment. A suitable sequence of ageing treatments include:

a first ageing step of 4 h at 1,120 °C, and
a second ageing step of 24 h at 845 °C.

Following this heat treatment process, a component such as turbine aerofoil (100) is provided which may have superior properties to turbine aerofoils of the prior art. The method of the present invention used to form this component may be more efficient and cost effective than the methods of the prior art.

In summary, the present invention provides a method of forming a component, for example a turbine aerofoil, the component comprising a first metal alloy composition in at least a first region of the component and a second metal alloy composition in at least a second region of the component. The method comprises depositing the first and second metal alloy compositions into different sections of a mould, applying pressure to the first and second metal alloy compositions in the mould and applying a Spark Plasma Sintering process to the metal alloys. The product of this process may then be used in investment casting to form an outer layer of the component. The component comprising the outer layer may then be subjected to a further Spark Plasma Sintering process to bind parts of the component together. The component may then be heat treated. Apparatus for carrying out such methods are also provided.

Throughout this specification, the term "comprising" or "comprises" means including the component(s) specified but not to the exclusion of the presence of other components. The term "consisting essentially of" or "consists essentially of" means including the components specified but excluding other components except for materials present as impurities, unavoidable materials present as a result of processes used to provide the components, and components added for a purpose other than achieving the technical effect of the invention. Typically, when referring to compositions, a composition consisting essentially of a set of components will comprise less than 5% by weight, typically less than 3% by weight, more typically less than 1 % by weight of non-specified components.

The term "consisting of" or "consists of" means including the components specified but excluding addition of other components.

Whenever appropriate, depending upon the context, the use of the term "comprises" or "comprising" may also be taken to encompass or include the meaning "consists essentially of" or "consisting essentially of", and may also be taken to include the meaning "consists of" or "consisting of".

For the avoidance of doubt, wherein amounts of components in a composition are described in wt%, this means the weight percentage of the specified component in relation to the whole composition referred to. For example, "a metal alloy comprising 6.0 to 7.5 wt% aluminium" means that 6.0-7.5 wt% of the metal alloy is provided by aluminium.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

**Claims**

1. A method of forming a component, the component comprising a first metal alloy composition in at least a first region of the component and a second metal alloy composition in at least a second region of the component, the method comprising the steps of:

   a) depositing the first metal alloy composition into a first section of a mould;
   b) depositing the second metal alloy composition into a second section of the mould, wherein the first and second metal alloy compositions are in contact with each other;
   c) applying a pressure to the first and second metal alloy compositions in the mould;
   d) applying an electrical current to the first and second metal alloy compositions to heat and sinter the first and second metal alloy compositions to form the component; and
   e) removing the component from the mould.

2. The method of claim 1 comprising a further step f) placing the component in a second mould and investment casting an outer layer around the component in the second mould.

3. The method according to claim 2, wherein step f) comprises the steps of:

   f1) depositing a first molten metal alloy composition into a first section of the second mould;
   f2) depositing a second molten metal alloy composition into a second section of the second mould, wherein the first and second molten metal alloy compositions are in contact with each other.

4. The method according to claim 2 or claim 3, wherein step f) is adapted to form the outer layer as a single crystal material.

5. The method according to any one of the preceding claims comprising a further step g) of placing the component in contact with a second component.

6. The method according to any one of the preceding claims comprising a further step h) of applying an electrical current to the component to heat the component and bind parts of the component together and/or to bind the component to a second component.

7. The method according to claim 6, wherein step h) is carried out whilst applying pressure to the component and to the second component, if present.

8. An apparatus adapted to carry out the method of any of claims 1 to 7, the apparatus comprising:

   a mould defining the shape of the component for receiving material;
   electrodes arranged to supply electricity through material placed in the mould; and
   a press arranged to apply pressure to material placed in the mould.

9. The apparatus according to claim 8, comprising at least two pairs of electrodes, each arranged to supply electricity through material in different sections of the mould.

**10.** The apparatus according to claim 8 or claim 9, comprising at least two presses arranged to apply pressure to material in different sections of the mould.

**11.** A method of forming a component comprising a component core and an outer layer, the component comprising a first metal alloy composition in at least a first region of the outer layer and a second metal alloy composition in at least a second region of the outer layer, the method comprising the steps of:

   f) placing a component core in an investment casting mould;
   f1) depositing a first molten metal alloy composition into a first section of the investment casting mould;
   f2) depositing a second molten metal alloy composition into a second section of the investment casting mould, wherein the first and second molten metal alloy compositions are in contact with each other;
   f4) allowing the first molten metal alloy composition and the second molten metal alloy composition to solidify to form single crystal outer layer around the component core.

**12.** An apparatus for carrying out the method of claim 11, the apparatus comprising:

   a chill plate adapted for supporting the component core;
   a mould comprising first and second inlets, the mould adapted for enclosing the component core and for receiving the first and second molten metal alloy compositions through the first and second inlets respectively;
   a first reservoir for supplying the first molten metal alloy composition to the mould through the first inlet; and
   a second reservoir for supplying the second molten metal alloy composition to the mould through the second inlet.

**13.** A method of forming a component comprising at least two component parts, the method comprising the steps of:

   g) arranging the at least two component parts in contact with each other;
   h) applying an electrical current to the at least two component parts to heat component parts and bind the at least two component parts together.

**14.** The method according to claim 13 wherein the at least two component parts comprise an inner core and an outer layer.

**15.** A component comprising an inner core region and an outer layer, wherein the inner core region comprises a polycrystalline metal alloy composition and wherein the outer layer comprises a single crystal metal alloy composition.

**Fig. 1**

**Fig. 2**

**Fig. 3**

Europäisches
Patentamt

European
Patent Office

Office européen
des brevets

# EUROPEAN SEARCH REPORT

**Application Number**

EP 18 17 5498

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2015/122953 A2 (SIEMENS ENERGY INC [US]) 20 August 2015 (2015-08-20) * paragraphs [0004] - [0008] * ----- | 1-10,13, 14 | INV. B22D19/04 B22D19/16 B22F3/105 |
| X | US 2016/121400 A1 (COURET ALAIN [FR] ET AL) 5 May 2016 (2016-05-05) | 8-10 | B22F5/00 B22F5/04 |
| A | * claim 1 * ----- | 5-7 | B22F7/06 C30B11/00 |
| X | EP 3 210 691 A1 (GEN ELECTRIC [US]) 30 August 2017 (2017-08-30) | 11,12 | C30B29/52 |
| A | * paragraphs [0001], [0006], [0026]; figure 4 * ----- | 3,4 | |
| X | DE 10 2014 204347 A1 (SIEMENS AG [DE]) 10 September 2015 (2015-09-10) | 13,14 | |
| A | * claim 1 * ----- | 5-7,9,10 | |
| X | US 5 061 154 A (KINGTON HARRY L [US]) 29 October 1991 (1991-10-29) | 15 | |
| A | * column 4, line 33 - line 37 * * column 4, line 45 - line 53 * * figures 1-2 * ----- | 4 | |
| X | EP 1 231 010 A1 (SIEMENS WESTINGHOUSE POWER [US]) 14 August 2002 (2002-08-14) * paragraph [0053] * ----- | 15 | TECHNICAL FIELDS SEARCHED (IPC) B22D B22F C30B B22C |
| A | WO 95/30503 A1 (DTM CORP [US]) 16 November 1995 (1995-11-16) * page 3, line 26 - line 31 * ----- | 2 | |

The present search report has been drawn up for all claims

| Place of search | Date of completion of the search | Examiner |
|---|---|---|
| The Hague | 2 August 2018 | Momeni, Mohammad |

## ANNEX TO THE EUROPEAN SEARCH REPORT
## ON EUROPEAN PATENT APPLICATION NO.

EP 18 17 5498

This annex lists the patent family members relating to the patent documents cited in the above-mentioned European search report.
The members are as contained in the European Patent Office EDP file on
The European Patent Office is in no way liable for these particulars which are merely given for the purpose of information.

02-08-2018

| Patent document cited in search report | | Publication date | Patent family member(s) | | Publication date |
|---|---|---|---|---|---|
| WO 2015122953 | A2 | 20-08-2015 | US 2016158840 A1<br>WO 2015122953 A2 | | 09-06-2016<br>20-08-2015 |
| US 2016121400 | A1 | 05-05-2016 | CN 105451915 A<br>EP 3007844 A1<br>FR 3006696 A1<br>JP 2016526602 A<br>KR 20160033096 A<br>PL 3007844 T3<br>US 2016121400 A1<br>WO 2014199082 A1 | | 30-03-2016<br>20-04-2016<br>12-12-2014<br>05-09-2016<br>25-03-2016<br>28-02-2018<br>05-05-2016<br>18-12-2014 |
| EP 3210691 | A1 | 30-08-2017 | CA 2958064 A1<br>CN 107127301 A<br>EP 3210691 A1<br>JP 2017154181 A<br>US 2017246678 A1 | | 29-08-2017<br>05-09-2017<br>30-08-2017<br>07-09-2017<br>31-08-2017 |
| DE 102014204347 A1 | | 10-09-2015 | DE 102014204347 A1<br>WO 2015135680 A1 | | 10-09-2015<br>17-09-2015 |
| US 5061154 | A | 29-10-1991 | CA 2069109 A1<br>EP 0505507 A1<br>JP H05502711 A<br>US 5061154 A<br>WO 9109209 A1 | | 12-06-1991<br>30-09-1992<br>13-05-1993<br>29-10-1991<br>27-06-1991 |
| EP 1231010 | A1 | 14-08-2002 | EP 1231010 A1<br>JP 2002303155 A<br>US 2002148115 A1 | | 14-08-2002<br>18-10-2002<br>17-10-2002 |
| WO 9530503 | A1 | 16-11-1995 | NONE | | |

EPO FORM P0459

For more details about this annex : see Official Journal of the European Patent Office, No. 12/82

**EP 3 575 016 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6331217 B